(19) Europäisches Patentamt European Patent Office Office européen des brevets

(11) **EP 3 167 623 B1**

(12) **EUROPEAN PATENT SPECIFICATION**

(45) Date of publication and mention
of the grant of the patent:
**30.08.2023 Bulletin 2023/35**

(21) Application number: **15741704.9**

(22) Date of filing: **07.07.2015**

(51) International Patent Classification (IPC):
*H04R 1/02* *(2006.01)*    *H04R 1/08* *(2006.01)*
*H04R 19/04* *(2006.01)*

(52) Cooperative Patent Classification (CPC):
**H04R 1/086; H04R 19/005;** B81B 2201/0257;
H04R 1/023; H04R 2201/003

(86) International application number:
**PCT/US2015/039317**

(87) International publication number:
**WO 2016/007469 (14.01.2016 Gazette 2016/02)**

(54) **APPARATUS AND METHOD FOR PROTECTING A MICRO-ELECTRO-MECHANICAL SYSTEM**

VORRICHTUNG UND VERFAHREN ZUM SCHUTZ EINES MIKROELEKTROMECHANISCHEN
SYSTEMS

APPAREIL ET PROCÉDÉ POUR PROTÉGER UN SYSTÈME MICRO-ÉLECTROMÉCANIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.07.2014 US 201462021303 P
06.07.2015 US 201514791955**

(43) Date of publication of application:
**17.05.2017 Bulletin 2017/20**

(73) Proprietor: **W. L. Gore & Associates, Inc.
Newark, DE 19711 (US)**

(72) Inventor: **HOLLIDAY, Andrew J.
Newark, DE 19711 (US)**

(74) Representative: **HGF
HGF Limited
1 City Walk
Leeds LS11 9DX (GB)**

(56) References cited:
WO-A1-2004/062318    WO-A2-01/03468
CN-A- 101 242 889    US-A1- 2007 012 624
US-A1- 2007 012 624    US-A1- 2014 138 181
US-B1- 8 672 851

• LIU AI-LI ET AL: "Simulation on sound
transmission loss of PTFE Micro-aperture
Membrane", NANO/MICRO ENGINEERED AND
MOLECULAR SYSTEMS, 2008. NEMS 2008. 3RD
IEEE INTERNATIONAL CONFERENCE ON, IEEE,
PISCATAWAY, NJ, USA, 6 January 2008
(2008-01-06), pages 202-205, XP031263423, ISBN:
978-1-4244-1907-4

**EP 3 167 623 B1**

## Description

## BACKGROUND OF THE INVENTION

The integration of mechanical elements, sensors, actuators or the like and electronics on a common silicon substrate through micro-fabrication technology is known as micro-electro-mechanical system ("MEMS"). MEMS sensors may be used in microphones, consumer pressure sensor applications, tire pressure monitoring systems, gas flow sensors, accelerometers, and gyroscopes.

A known silicon condenser microphone MEMS package includes an acoustic transducer and acoustic port. The acoustic port further includes an environmental barrier such as polytetrafluoroethylene (PTFE) or a sintered metal to protect the transducer from environmental elements such as sunlight, moisture, oil, dirt, and/or dust. Acoustic transducers include speakers and microphones.

Expanded PTFE (ePTFE) membranes have been used for protecting acoustic transducers for many years. Recently, several applications for protecting ultrasonic transducers have come out. Two examples are: (1) a transmitter, and possibly receiver, of short ultrasonic pulses for gesture recognition (alternatively, standard acoustic microphones can be used to receive the signal) and or proximity sensing. The time of flight of these pulses are used to determine the 3D location of a hand/finger and or distance to an object; (2) a MEMS digital loudspeaker. The latter is created with an array of ultrasonic transmitters that create ultrasonic pulses which digitally recreate an audible signal.

The difference in intended frequency transmission between acoustic (audible) and ultrasonic applications require different membrane properties for any protective cover. When transmitting near or below the resonant frequency of a reactive protective cover, the stiffness/compliance of an ePTFE membrane is the material property which can be correlated to acoustic transmission. Typical non-ePTFE alternatives include silicone and urethane films for these applications. Above the resonance frequency of reactive protective cover, applicants have discovered that the mass/area of the membrane is the critical attribute that drives transmission. For that reason, a low mass ePTFE is desired.

US patent no. US 8672851 to Quirk et al. describes a three-dimensional ultrasoundbased assessment device, comprising a flexible membrane disposed across an opening at the front end of a housing, and an ultrasound transducer assembly. US patent application no. US 2014/138181 to Mori describes a sound-transmitting membrane that allows passage of sounds and prevents passage of foreign matters including a supporting member and a resin porous membrane layered on the supporting membrane and containing polytetrafluoroethylene (PTFE) as a main component. US patent application no. US 2007/012624 to Bacino et al. describes porous PTFE membranes. International patent application no. WO 01/03468 to Gore Enterprise Holdings, Inc. describes a sound-transmissive cover assembly that provides protection from the ambient environment to transducer device. Liu et al. ("Simulation on sound transmission loss of PTFE Micro-aperture Membrane", Nano/Micro Engineered and Molecular Systems, 2008, pages 202-205) describes simulations of PTFE membrane performance regarding sound transmission and losses of less than 10 dB. International patent application no. WO 2004/062318 to W.L. Gore & Associates GMBH describes an electrostatically chargeable polymer membrane for acoustic transducers comprising expanded PTFE (ePTFE) and condensed ePTFE.

A need also still exists for environmental protection and pressure equalization capability in a thin form factor as required by a MEMS package.

## SUMMARY

Embodiments of the invention are defined as per the appended claims.

According to the present invention, a method of protecting a micro-electro-mechanical system having an ultrasonic transducer is provided by disposing adjacent to the ultrasonic transducer an expanded PTFE membrane having a mass/area ratio of less than about 1 g/m$^2$. The expanded PTFE membrane may capture particles greater than about 0.25 microns in diameter, the expanded PTFE membrane provides transmission loss of less than about 3dB at a frequency of about 50 to about 92.5 KHz. The expanded PTFE membrane may provide sonic transmission, particle capture, and pressure venting.

In another aspect, the invention provides a micro-electro-mechanical system comprising an ultrasonic transducer and an expanded PTFE protective cover having a mass/area ratio of about 1 g/m$^2$ or less disposed adjacent to the ultrasonic transducer and provides transmission loss of less than 3dB at a frequency of 50 to 92.5 kHz.

In still another aspect not specifically claimed, a method of protecting a micro-electro-mechanical system having an ultrasonic transducer is provided by disposing adjacent to the ultrasonic transducer a porous polymeric material that satisfies the relationship:

$$\frac{m}{A} < 10^{(3/5)} \frac{Z_{air}}{2\pi f};$$

where

Zair = Specific Acoustic Impedance of Air (rayls) = 413;

$\frac{m}{A}$ = Mass per area (kg/m$^2$);

f = Frequency (Hz),
f > 20 KHz

In alternative embodiments, the equation is:

$$\frac{m}{A} < 10^{(3/10)} \frac{Z_{air}}{2\pi f}$$

And in other alternatives: :

$$\frac{m}{A} < 10^{(3/20)} \frac{Z_{air}}{2\pi f}$$

## BRIEF DESCRIPTION OF THE DRAWINGS

Fig. 1 is a schematic of the test method used to test an embodiment of the invention.
Fig. 2 is a plot of mass/area vs acoustic performance (amplification) for additional exemplary embodiments of the invention.
Fig. 3 is a scanning electron micrograph of an exemplary embodiment of the invention.

## DETAILED DESCRIPTION

In one embodiment not of the claimed invention, the present disclosure provides a protective cover for a micro-electro-mechanical system that has a low mass/area of <1gsm. In an embodiment, the disclosure provides a method of protecting a micro-electro-mechanical system having an ultrasonic transducer comprising the step of disposing adjacent to said ultrasonic transducer an expanded PTFE membrane having a mass/area ratio of about less than 1 g/m$^2$, and provides transmission loss of less than 3dB at a frequency of 50 to 92.5 kHz. In another embodiment, the disclosure provides a micro-electro-mechanical system comprising an ultrasonic transducer and an expanded PTFE protective cover having a mass/area ratio of less than about 1 g/m$^2$ disposed adjacent to said ultrasonic transducer, and provides transmission loss of less than 3dB at a frequency of 50 to 92.5 kHz.

The present disclosure involves the use of a protective cover for a micro-electro-mechanical system that has a mass/area of <1gsm. Such a protective cover surprisingly functions both to keep particulate matter larger than about 0.25 microns away from the device protected, as well as allowing acoustic transmission with a loss of less than about 3dB at a frequency range of about 50-92.5KHz. The protective cover must also be durable enough to survive the packaging process, surface mount technology application, and through its intended use.

The protective cover is a porous membrane of ePTFE. Suitable porous membranes in preferred embodiments are made according to the teachings of US patent number 3,953,566 and 7,306,729 to have the following properties: mass/area less than 1gsm; machine direction matrix tensile strength greater than about 172.4 MPa (25 kpsi); transverse direction matrix tensile strength greater than about 206.8 MPa (30 kpsi); bubble point greater than about 30; a filtration effectiveness for 0.25 micron particles of at least about 99.9%; and a Gurley number of between about 1 and 2.

The mass/area of the membrane was calculated by measuring the mass of a welldefined area of the sample using a scale. The sample was cut to a defined area using a die or any precise cutting instrument. The Gurley air flow test measures the time in seconds for 100 cm$^3$ of air to flow through a 6.45 cm$^2$ sample at 12.4 cm of water pressure. The samples were measured in a Gurley Densometer Model 4340 Automatic Densometer.

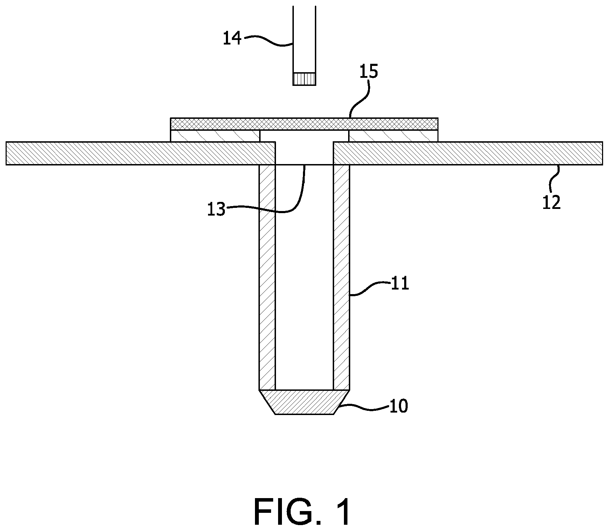

A sample of a porous membrane was constructed as described above. It had a mass/area of 1.2 g/m$^2$, a Gurley number of 1.1 seconds, and an acoustic loss of 1.8dB at a frequency of 50-92.5KHz. The testing method is described below in connection with Figure 1.

With reference to Fig. 1, inside of an anechoic chamber, a Tannoy Super Tweeter ultrasonic speaker 10 is mounted vertically. PVC tubing 11 with a 3.81 cm (1.5 inches) diameter is sealed to the front of speaker 10. The other end of PVC tubing 11 is coupled to a wooden baffle 12 with a matching 3.81 cm (1.5 inch) diameter hole 13. A B&K4939 microphone 14 is mounted approximately 5.08 cm (2 inches) from the surface of wooden baffle 12. Speaker 10 is amplified with a B&K2716C amplifier, and the microphone is powered by a B&K NEXUS conditioning amplifier. After microphone 14 is calibrated and mounted, speaker 10 generates a stepped sweep from a 92.5 kHz tone to a 20 kHz tone at a 12$^{th}$ octave step size. The sweep is generated with a constant 900mV excitation voltage. Microphone 14 records the sound pressure level at each step, creating a curve recorded as the "open condition." Membrane 15 is mounted to wooden baffle 12 using a ring of double-sided pressure sensitive adhesive with a 2.54 cm and 1.91 cm (1 and ¾ inch) inner diameter. The frequency sweep is then repeated, and the sound pressure at each frequency is again recorded. This curve is subtracted from the open condition to create an attenuation curve. The attenuation between 50-92.5 kHz is averaged to summarize the ultrasonic attenuation.

A third octave band centered around 60KHz was chosen, the average amplification within this octave band is shown in Table 1 for a wide range of ePTFE membranes.

Table 1

| Mass (g/m$^2$) | Amplification (dB) |
|---|---|
| 0.14 | -1.21875 |
| 0.3 | -0.01875 |
| 1 | -2.3 |
| 1.5 | -2.49375 |
| 1.6 | -3.31 |

(continued)

| Mass (g/m$^2$) | Amplification (dB) |
|---|---|
| 2.7 | -4.97125 |
| 3.1 | -7.1125 |
| 3.5 | -7.13 |
| 3.7 | -7.9875 |
| 4.1 | -7.19 |
| 6 | -12.60375 |

Further disclosed but not specifically claimed is a method of protecting a micro-electro-mechanical system having an ultrasonic transducer is provided by disposing adjacent to the ultrasonic transducer a porous polymeric material that satisfies the relationship:

$$\frac{m}{A} < 10^{(3/5)}\frac{Z_{air}}{2\pi f};$$

where

$Z_{air}$ = Specific Acoustic Impedance of Air (rayls) = 413;

$\frac{m}{A}$ = Mass per area (kg/m$^2$);

$f$ = Frequency (Hz),
f > 20 KHz

Alternatively, the equation is:

$$\frac{m}{A} < 10^{(3/10)}\frac{Z_{air}}{2\pi f}$$

And in other alternatives: :

$$\frac{m}{A} < 10^{(3/20)}\frac{Z_{air}}{2\pi f}$$

The first equation covers an acoustic loss b/w 0 -12dB, the second equation: 0 - 6dB, the third one 0 - 3dB.

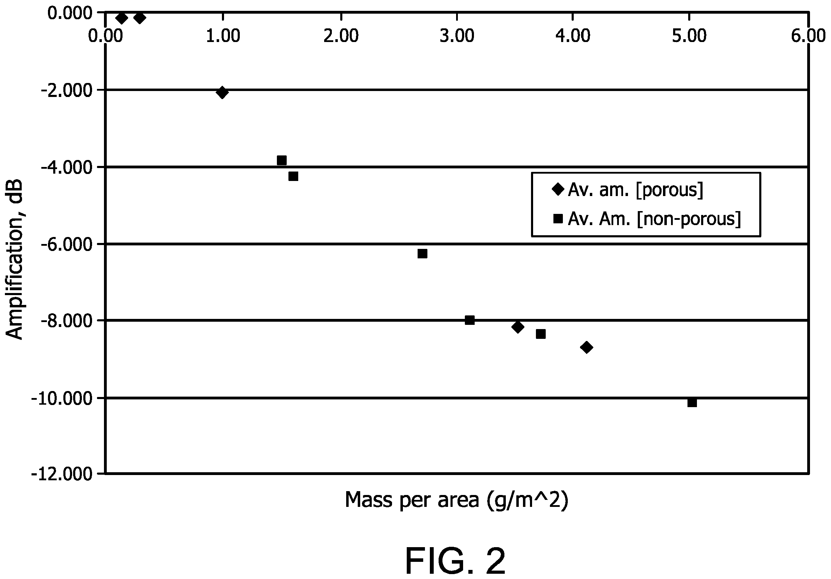

Fig. 2 is a plot of mass/area vs acoustic performance (amplification or acoustic loss) for additional exemplary embodiments of the disclosure.

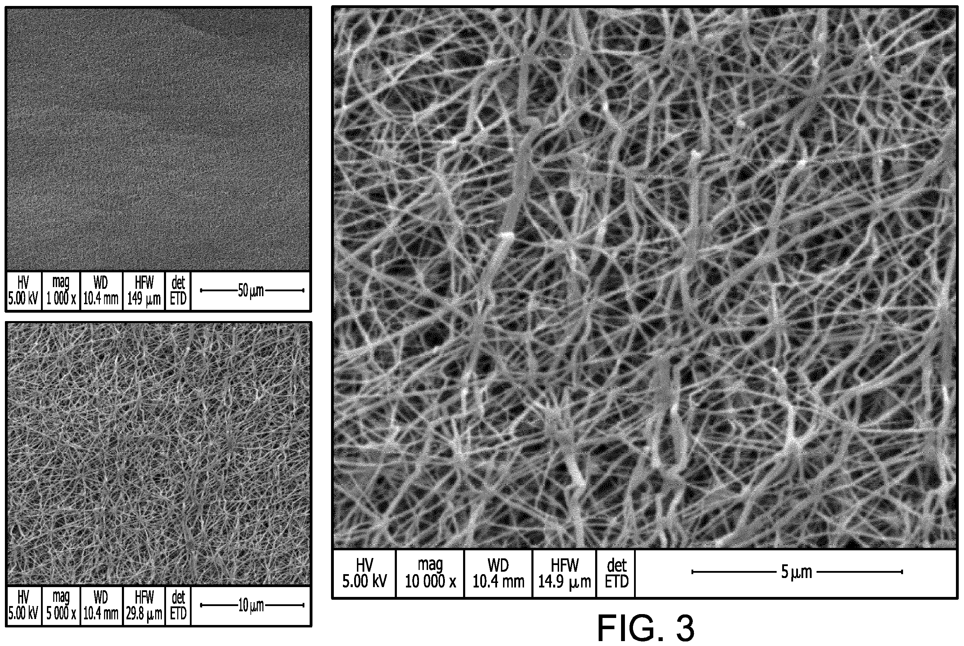

Fig. 3 is a scanning electron micrograph showing the microstructure an exemplary embodiment of the disclosure.

**Claims**

1. A method of protecting a micro-electro-mechanical system having an ultrasonic transducer (10) comprising the step of disposing adjacent to said ultrasonic transducer (10) an expanded PTFE membrane (15), **characterized in that** said expanded PTFE membrane (15) has a mass/area ratio of less than 1 g/m$^2$, and provides transmission loss of less than 3dB at a frequency of 50 to 92.5 kHz.

2. A method as defined in claim 1 wherein said expanded PTFE membrane (15) captures particles greater than 0.25 microns in diameter.

3. A method as defined in claim 1 wherein said expanded PTFE membrane (15) provides sonic transmission, particle capture, and pressure venting.

4. A micro-electro-mechanical system comprising an ultrasonic transducer (10) and an expanded PTFE membrane (15) disposed adjacent to said ultrasonic transducer (10), **characterized in that** said expanded PTFE membrane (15) has a mass/area ratio of less than 1 g/m$^2$, and provides transmission loss of less than 3dB at a frequency of 50 to 92.5 kHz.

5. A system as defined in claim 4 wherein said expanded PTFE membrane (15) captures particles greater than 0.25 microns in diameter.

6. A system as defined in claim 4 wherein said expanded PTFE membrane (15) provides sonic transmission, particle capture, and pressure venting.

**Patentansprüche**

1. Verfahren zum Schützen eines mikroelektromechanischen Systems, das einen Ultraschallwandler (10) aufweist, umfassend den Schritt des Anordnens einer expandierten PTFE-Membran (15) benachbart zu dem Ultraschallwandler (10), **dadurch gekennzeichnet, dass** die expandierte PTFE-Membran (15) ein Masse/Flächen-Verhältnis von weniger als 1 g/m$^2$ aufweist und Übertragungsverlust von weniger als 3 dB bei einer Frequenz von 50 bis 92,5 kHz bereitstellt.

2. Verfahren nach Anspruch 1, wobei die expandierte PTFE-Membran (15) Partikel mit einem Durchmesser von mehr als 0,25 Mikrometern einfängt.

3. Verfahren nach Anspruch 1, wobei die expandierte PTFE-Membran (15) Schallübertragung, Einfangen von Partikeln und Druckentlastung bereitstellt.

4. Mikroelektromechanisches System, umfassend einen Ultraschallwandler (10) und eine expandierte PTFE-Membran (15), die benachbart zu dem Ultraschallwandler (10) angeordnet ist, **dadurch gekennzeichnet, dass** die expandierte PTFE-Membran (15) ein Masse/Flächen-Verhältnis von weniger als 1 g/m$^2$ aufweist und Übertragungsverlust von weniger als 3 dB bei einer Frequenz von 50 bis 92,5 kHz bereitstellt.

5. System nach Anspruch 4, wobei die expandierte PTFE-Membran (15) Partikel mit einem Durchmesser von mehr als 0,25 Mikrometern einfängt.

6. System nach Anspruch 4, wobei die expandierte PTFE-Membran (15) Schallübertragung, Einfangen von Partikeln und Druckentlastung bereitstellt.

**Revendications**

1. Procédé de protection d'un système micro-électromécanique possédant un transducteur ultrasonore (10) comprenant l'étape de disposition adjacent audit transducteur à ultrasons (10) d'une membrane en PTFE expansé (15), **caractérisé en ce que** ladite membrane en PTFE expansé (15) possède une masse surfacique inférieure à 1 g/m$^2$ et fournit une perte de transmission inférieure à 3 dB à une fréquence de 50 à 92,5 kHz.

2. Procédé selon la revendication 1, ladite membrane en PTFE expansé (15) capturant des particules d'un diamètre supérieur à 0,25 micron.

3. Procédé selon la revendication 1, ladite membrane en PTFE expansé (15) fournissant une transmission sonique, une capture de particules et une évacuation de la pression.

4. Système micro-électromécanique comprenant un transducteur ultrasonore (10) et une membrane en PTFE expansé (15) disposée adjacente audit transducteur à ultrasons (10), **caractérisé en ce que** ladite membrane en PTFE expansé (15) possède un masse surfacique inférieur à 1 g/m$^2$ et fournit une perte de transmission inférieure à 3 dB à une fréquence de 50 à 92,5 kHz.

5. Système selon la revendication 4, ladite membrane en PTFE expansé (15) capturant des particules d'un diamètre supérieur à 0,25 micron.

6. Système selon la revendication 4, ladite membrane en PTFE expansé (15) fournissant une transmission sonique, une capture de particules et une évacuation de la pression.

FIG. 1

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8672851 B, Quirk
- US 2014138181 A, Mori
- US 2007012624 A, Bacino
- WO 0103468 A
- WO 2004062318 A
- US 3953566 A
- US 7306729 B

**Non-patent literature cited in the description**

- **LIU et al.** Simulation on sound transmission loss of PTFE Micro-aperture Membrane. *Nano/Micro Engineered and Molecular Systems,* 2008, 202-205